# EUROPEAN PATENT SPECIFICATION

(11) **EP 1 444 529 B1**
(45) Date of publication and mention of the grant of the patent: **20.08.2008**
(21) Application number: 02777646.7
(22) Date of filing: 24.10.2002
(51) Int. Cl.: G01R 33/561

(54) **MAGNETIC RESONANCE METHOD FOR FORMING A FAST DYNAMIC IMAGE**
AUF MAGNETISCHER RESONANZ BERUHENDES VERFAHREN ZUR ERSTELLUNG EINES SCHNELLEN DYNAMISCHEN BILDES
PROCEDE DE RESONANCE MAGNETIQUE POUR FORMER UNE IMAGE DYNAMIQUE RAPIDE

(30) Priority: 07.11.2001 EP 01204274
(43) Date of publication of application: 11.08.2004
(73) Proprietor: Koninklijke Philips Electronics N.V., 5621 BA Eindhoven (NL)
(72) Inventor: FUDERER, Miha, NL-5656 AA Eindhoven (NL)
(74) Representative: Cohen, Julius Simon
(86) International application number: PCT/IB2002/004443
(87) International publication number: WO 2003/040744

(56) References cited:
- WO-A-01/44827
- P. KELLMAN ET AL.: "Adaptive Sensitivity Encoding ..." MAGNETIC RESONANCE IN MEDICINE, vol. 45, May 2001 (2001-05), pages 846-852, XP002229780
- B. MADORE ET AL:: "Unaliasing by Fourier-Encoding ..." MAGNETIC RESONANCE IN MEDICINE, vol. 42, 1999, pages 813-828, XP002229781
- CH.A. MCKENZIE ET AL.: "Coil-by-Coil Image Resconstruction With SMASH" MAGNETIC RESONANCE IN MEDICINE, vol. 46, September 2001 (2001-09), pages 619-623, XP002229782

## Description

The invention relates to a magnetic resonance method for forming a dynamic image from a plurality of signals acquired by an array of multiple receiver antennae according to the preamble of claim 1. The invention also relates to a magnetic resonance imaging apparatus for obtaining a fast dynamic image according to the preamble of claim 5 and to a computer program product according to the preamble of claim 6.

In magnetic resonance imaging there is a general tendency to obtain acceptable images within shorter periods of time. For this reason the sensitivity encoding method called "SENSE" has recently been developed by the Institute of Biomedical Engineering and Medical Informations, University and ETH Zürich, Switzerland. The SENSE method is based on an algorithm which acts directly on the image as detected by the coils of the magnetic resonance apparatus and where subsequent encoding steps can be skipped and hence an acceleration of the signal acquisition for imaging by a factor of from two to three can be obtained. Crucial for the SENSE method is the knowledge of the sensitivity of the coils which are arranged in so called sensitivity maps. In order to accelerate this method there are proposals to use raw sensitivity maps which can be obtained through division by either the "sum-of-squares" of the single coil references or by an optional body coil reference (see e.g. K. Pruessmann et. al. in Proc. ISMRM, 1998, abstracts pp. 579, 799, 803 and 2087). In fact the SENSE method allows for a decrease in scan time by deliberately undersampling k-space, i.e. deliberately selecting a Field-of-View (FOV) that is smaller than the object to be acquired. From this undersampling fold-over artefacts are obtained which can be resolved or unfolded by the use of the knowledge of a set of distinct coils having different coil sensitivity patterns. The undersampling can be in either one of both phase-encoding directions.

The SENSE method is preferred for acceleration of the signal acquisition for magnetic resonance imaging resulting in an enormous reduction in operating time. However, the method can only be used properly if the coil sensitivity is exactly known. Otherwise imperfections will cause fold-over artefacts (aliasing) which lead to incorrect images. In practice the coil sensitivity cannot be estimated perfectly and will be dependent on fluctuations in time (movement of the patient, temperature influences, etc.).

Another important problem of the SENSE method is the spatially varying noise level in the resultant image. More specifically, the resultant image can have regions of extremely high noise level that are due to local "underdetermination" of the information provided by the coil patterns.

Another kind of undersampling may be applied in dynamic imaging as has been described in T.J. Provost, SMRI 1990, Works-in-progress, abstract 462. If a part of the object is known to be static, advantage can be taken from this knowledge. In the simplest case, where exactly one half of the FOV is known to be static, k-space density can be reduced be a factor of 2. This results in folding of image data. However, exactly one pixel of the dynamic object area overlaps with exactly one pixel of a static area. If, in whatever way the static image is known, the static aliasing can be subtracted from the required dynamic image part. That static image can be measured beforehand, afterwards, or by shifting k-space rows from one frame to the other, in order to reconstruct a non-aliased (but temporally blurred) image (see e.g. Madore, Glover and Pelc, MRM 42. p. 813-828 (1999)). where the steps/features defined in the preamble of the independent claims are describ

It is an object of the present invention to achieve a further acceleration of imaging of the above mentioned SENSE method.

This and other objects of the invention are achieved by a method as defined in claim 1, by an apparatus as defined in claim 5 and by a computer program product as defined in claim 6.

The main aspect of the present invention is based on the idea that an acceleration of the SENSE method is not only feasible by increasing the number of recording coils but also by making use of the intrinsic knowledge of the object to be imaged.

These and other advantages of the invention are disclosed in the claims and in the following description in which an exemplified embodiment of the invention is described with respect to the accompanying drawings. Therein shows:
Fig. 1 the normal imaging of voxels in the spatial domain onto pixels in the image domain,
Fig. 2 clusters in the spatial domain which are imaged onto a pixel in the image domain,
Fig. 3 an apparatus for carrying out the method in accordance with the present invention, and
Fig. 4 a circuit diagram of the apparatus as shown in Fig. 3.

The here described method applies to dynamic MRI sequences, whether in a cartesian or non-cartesian frame (like radial or spiral). It is assumed that at least a part of an object under study has interesting temporal frequencies of change up to f/2, which means that a frame has to be acquired every T_{D} = 1/f seconds. The object as a whole has a size of the Field-of-View (FOV), which would dictate a k-space step or density in case of non-cartesian scans of no more than Δk. Whereas it is assumed that no acceleration techniques are used.

The region to be imaged, whether a 2D slice or a 3D volume, is segmented into regions of "distinct temporal variability". This means that there is a region of slow variation below a predetermined threshold and a region of fast variation above said threshold. This segmentation requires a-priori data of the object to be scanned. This data may be obtained by the anatomical knowledge of the operator or by a preliminary scan. There are at least two types of regions. Each type is characterised by the expected range of temporal frequencies in that region. The region belonging to any given variability-type may be non-contiguous.

The acquisition sequence of the present method has the following characteristics:

An undersampling in k-space by any desired reduction factor a, which may be an integer or a non-integer number; the maximally allowable value of a is determined by the number of acquisition coils and by the data known from the object, in order to segment the FOV in a region of slow motion and in a region of fast motion. In case of 2D cartesian imaging, where only one phase-encoding direction exists, the k-space distance is increased to aΔk. With non-cartesian or 3D imaging in two phase-encoding directions, the density of k-space samples or profiles is reduced by a factor a.

A frame-to-frame change of k-space sampling positions: the pattern of change is repetitive, resulting in a "crystalline structure" of the filling of (k,t)-space. The choice of the period or repetitive pattern depends on whether we want to put more emphasis on the SENSE method for unfolding the sampled data or whether the main emphasis is on the unfolding by the segmentation or "variability-restrictive" knowledge of the scanned object.

The reconstruction method is essentially a SENSE reconstruction. It characteristic properties are that the unfolding is not performed purely in the spatial direction, but in a space spanning at least a spatial dimension and a temporal-frequency dimension and that the knowledge of the regional restrictions on the temporal frequencies is applied as input data for the regularisation.

This is basically accomplished in the following manner:
1. The raw data sampled by the receiving coils is Fourier transformed from the k-space domain to the temporal domain (x,y,z;t). In addition this data is transformed from the temporal domain to the temporal-frequency domain (x,y,z,ω). The last transformation is not necessarily a Fast Fourier Transformation (FFT) or Double Fourier Transformation (DFT), but may also be accomplished by a limited set of digital filters.
2. The Fourier Transformation of the sampling lattice is a structured lattice in (x,y,z,ω)-space, i.e. sets of points of that space mutually overlap due to the undersampling.
3. Using SENSE, the folding in (x,y,z,ω)-space is removed. Due to the knowledge on restricted variability of the scanned object, some parts of the resulting (x,y,z,ω)-space are known to be zero. This knowledge is used during the SENSE unfolding, e.g. by regularisation. This allows for a number of folded points that exceeds the number of receiving coils.
4. The resulting data is Fourier transformed from the temporal-frequency domain to the temporal domain.

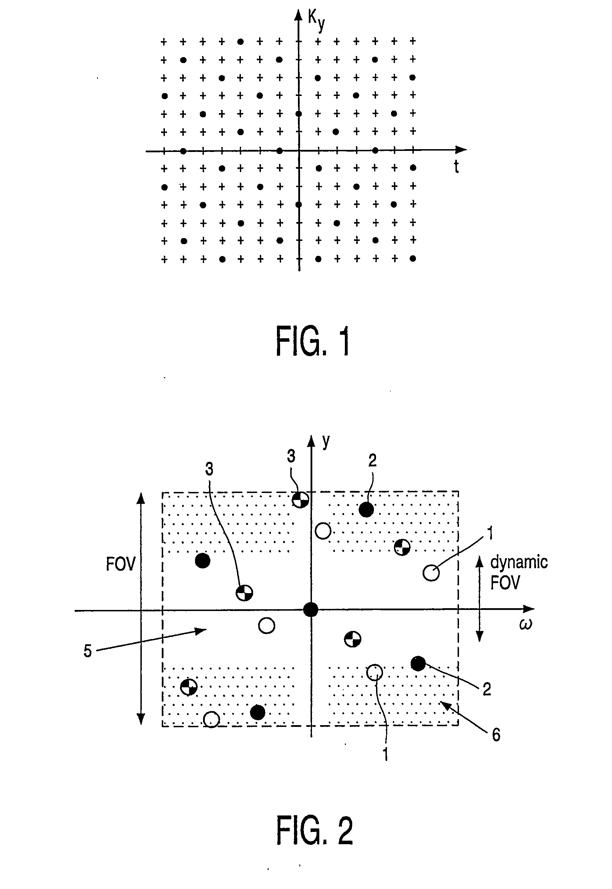

As an example the above described method is applied to dynamic 2D imaging of the cardiac region. It is assumed that there are three receiving coils and two distinct regions: a region of 60% of the FOV exhibiting a slow motion (e.g. respiratory motion) and 40% of the FOV exhibiting rapid variations (e.g. the heart region). Further it is assumed for simplicity that the rapid region is parallel to the x-axis and that all folding or unfolding is performed in the y- or phase-encoding direction. This allows for example a speed improvement of a factor of 5 compared with the normal or full sampling. In Fig. 1 the normal frame in k-space is depicted, wherein the crosses represent the full sampling and the bullets represent the undersampling of the method described above. If now the lattice of the bullets in Fig. 1 is transformed to the temporal-frequency space, the situation of Fig. 2 will be obtained. In this figure the information from all positions of the five circles 1 will fold onto one single measurement point for each coil. This means that the information from these circles 1 will mutually overlap. In the same manner the information from the bullets 2 and from the crosses 3 is also overlapped. From the knowledge or preliminar information of the object to be scanned it is known that some regions of the temporal-frequency domain or (y, ω)-space must be empty. This means that the full FOV is restricted to a dynamic FOV with only a limited temporal-frequency bandwidth, which is the empty space 5 between the dotted areas 6, which represent the slow motion parts of the scanned object and are set to zero. Thus, in effect, only three circles 1, three crosses 2 and two bullets 3 have to be unfolded. If there are at least three receiving coils, unfolding is always possible.

Therefore, the attained acceleration factor can be partly attributed to the unfolding by the SENSE method and partly to the "knowledge on dynamics" or the information of the object to be scanned.

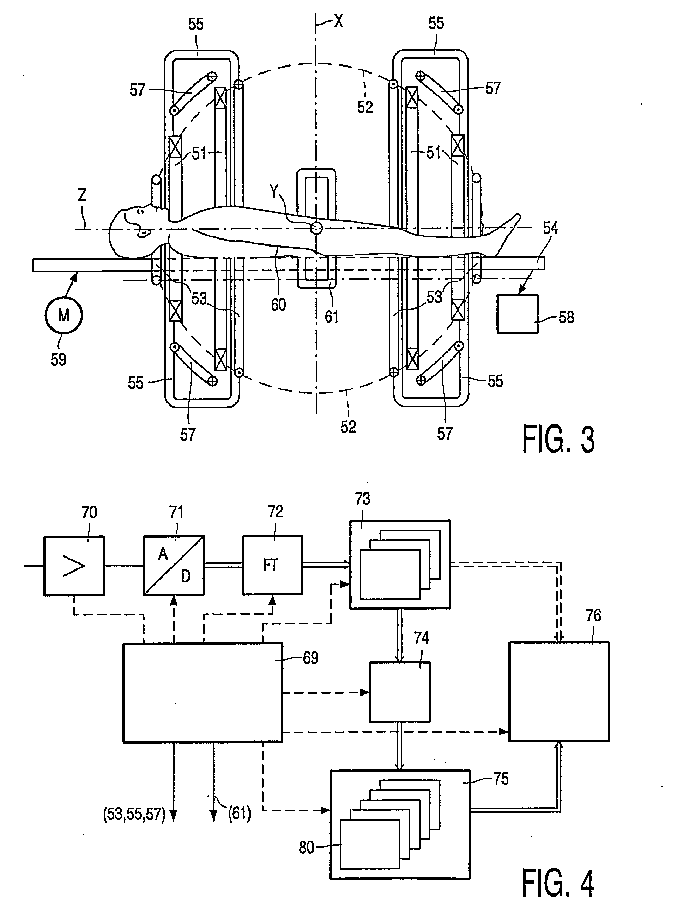

The apparatus shown in Fig. 3 is an MR apparatus which comprises a system of four coils 51 for generating a steady, uniform magnetic field whose strength is of the order of magnitude of from some tenths of Tesla to some Tesla. The coils 51, being concentrically arranged relative to the z axis, may be provided on a spherical surface 52. The patient 60 to be examined is arranged on a table 54 which is positioned inside these coils. In order to produce a magnetic field which extends in the z direction and linearly varies in this direction (which field is also referred to hereinafter as the gradient field), four coils 53 as multiple receiver antennae are provided on the spherical surface 52. Also present are four coils 57 which generate a gradient field which also extends (vertically) in the x direction. A magnetic gradient field extending in the z direction and having a gradient in the y direction (perpendicularly to the plane of the drawing) is generated by four coils 55 which may be identical to the coils 57 but are arranged so as to be offset 90° in space with respect thereto. Only two of these four coils are shown here.

Because each of the three coil systems 53, 55, and 57 for generating the magnetic gradient fields is symmetrically arranged relative to the spherical surface, the field strength at the centre of the sphere is determined exclusively by the steady, uniform magnetic field of the coil 51. Also provided is an RF coil 61 which generates an essentially uniform RF magnetic field which extends perpendicularly to the direction of the steady, uniform magnetic field (i.e. perpendicularly to the z direction). The RF coil receives an RF modulated current from an RF generator during each RF pulse The RF coil 61 can also be used for receiving the spin resonance signals generated in the examination zone.

As is shown in Figure 4 the MR signals received in the MR apparatus are amplified by a unit 70 and transposed in the baseband. The analog signal thus obtained is converted into a sequence of digital values by an analog-to-digital converter 71. The analog-to-digital converter 71 is controlled by a control unit 69 so that it generates digital data words only during the read-out phase. The analog-to-digital converter 71 is succeeded by a Fourier transformation unit 72 which performs a one-dimensional Fourier transformation over the sequence of sampling values obtained by digitization of an MR signal, execution being so fast that the Fourier transformation is terminated before the next MR signal is received.

The raw data thus produced by Fourier transformation is written into a memory 73 whose storage capacity suffices for the storage of several sets of raw data. From these sets of raw data a composition unit 74 generates a composite image in the described manner; this composite image is stored in a memory 75 whose storage capacity suffices for the storage of a large number of successive composite images 80. These sets of data are calculated for different instants, the spacing of which is preferably small in comparison with the measurement period required for the acquisition of a set of data. A reconstruction unit 76, performing a composition of the successive images, produces MR images from the sets of data thus acquired, said MR images being stored. The MR images represent the examination zone at the predetermined instants. The series of the MR images thus obtained from the data suitably reproduces the dynamic processes in the examination zone.

The units 70 to 76 are controlled by the control unit 69. As denoted by the downwards pointing arrows, the control unit also imposes the variation in time of the currents in the gradient coil systems 53, 55 and 57 as well as the central frequency, the bandwidth and the envelope of the RF pulses generated by the RF coil 61. The memories 73 and 75 as well as the MR image memory (not shown) in the reconstruction unit 76 can be realized by way of a single memory of adequate capacity. The Fourier transformation unit 72, the composition unit 74 and the reconstruction unit 76 can be realized by way of a data processor well-suited for running a computer program according the above mentioned method.

## Claims

1. A magnetic resonance imaging method for forming a dynamic image wherein
- a stationary magnetic field and temporary magnetic gradient fields are applied,
- a plurality of magnetic resonance signals are acquired in an undersampled fashion by means of an array of multiple receiver antennae, the magnetic resonance signals being spatially encoded on the basis of the temporary gradient fields, **characterized in that**
- the object to be imaged is segmented into a region of slow variation below a predetermined threshold and into a region of fast variation above said threshold which region defines a dynamic FOV being restricted with respect to the overall FOV of the object to be imaged,
- signals in the overall FOV are sampled in k-space with a reduction factor, which depends on the number of acquisition receiver antennae and the segmentation of the FOV,
- the k-space sampling signals in the dynamic FOV are transformed by Fourier Transformation to the temporal domain, which data is transformed additionally to the temporal-frequency domain,
- the acquired data in the temporal-frequency domain derived from the undersampled signals in k-space are unfolded on the basis of the spatial sensitivity profiles of the array of receiver antennae, whereas data transformed from signals of the k-space domain related to the region of slow variation are set to zero, and
- the resulting data in the temporal-frequency domain is Fourier transformed to the temporal domain.

2. A magnetic resonance imaging method according to Claim 1, wherein the reduction factor is an integer or non-integer number greater than 1.

3. A magnetic resonance imaging method according to Claim 1 or 2, wherein the transformation from k-space to the temporal-frequency domain is a Fourier Transformation.

4. A magnetic resonance imaging method according to Claim 1 or 2, wherein the transformation from k-space to the temporal-frequency domain is accomplished by a predetermined set of digital filters.

5. A magnetic resonance imaging apparatus for obtaining a dynamic image from a plurality of signals comprising
- means for applying a stationary magnetic field and temporary magnetic gradient fields,
- an array of multiple receiver antennae for acquiring a plurality of magnetic resonance signals in an undersampled fashion, the magnetic resonance signals being spatially encoded on the basis of the temporary gradient fields,
**characterized by** further comprising
- means for segmenting the object to be imaged into a region of slow variation below a predetermined threshold and into a region of fast variation above said threshold which region defines a dynamic FOV being restricted with respect to the overall FOV of the object to be
- means for sampling signals in the overall FOV in k-space with a reduction factor, which depends on the number of acquisition receiver antennae and the segmentation of the FOV,
- means for transforming the k-space sampling signals in the dynamic FOV by Fourier Transformation to the temporal domain, which data is transformed additionally to the temporal-frequency domain,
- means for unfolding the acquired data in the temporal-frequency domain derived from the undersampled signals in k-space on the basis of the spatial sensitivity profiles of the array of receiver antennae, whereas data transformed from signals of the k-space domain related to the region of slow variation are set to zero, and
- means for Fourier transforming the resulting data in the temporal-frequency domain to the temporal domain.

6. A computer program product stored on a computer usable medium for forming an image by means of a magnetic resonance method, comprising a computer readable program mean for causing the computer to control the execution of:
- applying a stationary magnetic field and temporary magnetic gradient fields,
- acquiring a plurality of magnetic resonance signals in an undersampled fashion by means of an array of multiple receiver antennae, the magnetic resonance signals being spatially encoded on the basis of the temporary gradient fields,
**characterized by** further comprising
- segmenting the object to be imaged into a region of slow variation below a predetermined threshold and into a region of fast variation above said threshold which region defines a dynamic FOV being restricted with respect to the overall FOV of the object to be imaged,
- sampling signals in the overall FOV in k-space with a reduction factor, which depends on the number of acquisition receiver antennae and the segmentation of the FOV,
- transforming the k-space sampling signals in the dynamic FOV by Fourier Transformation to the temporal domain, which data is transformed additionally to the temporal-frequency domain,
- unfolding the acquired data in the temporal-frequency domain derived from the undersampled signals in k-space on the basis of the spatial sensitivity profiles of the array of receiver antennae, whereas data transformed from signals of the k-space domain related to the region of slow variation are set to zero, and
- Fourier transforming the resulting data in the temporal-frequency domain to the temporal domain.

## Patentansprüche

1. Magnetresonanz-Bildgebungsverfahren zum Erstellen eines dynamischen Bildes, wobei
- ein stationäres Magnetfeld und temporäre magnetische Gradientenfelder angelegt werden,
- eine Vielzahl von Magnetresonanzsignalen auf unterabgetastete Weise mit Hilfe einer Anordnung aus mehreren Empfängerantennen erfasst werden, wobei die Magnetresonanzsignale auf der Basis der temporären Gradientenfelder räumlich codiert sind, **dadurch gekennzeichnet, dass**
- das abzubildende Objekt in eine Region langsamer Veränderung unterhalb eines vorgegebenen Schwellenwertes und eine Region schneller Veränderung oberhalb des genannten Schwellenwertes segmentiert wird, wobei die Region ein dynamisches Sichtfeld (FOV = Field of View) definiert, das in Bezug auf das Gesamtsichtfeld des abzubildenden Objekts eingeschränkt ist,
- Signale in dem Gesamtsichtfeld im k-Raum mit einem Reduzierungsfaktor abgetastet werden, der von der Anzahl der Erfassungs-Empfangsantennen und der Segmentierung des Sichtfeldes abhängt,
- die k-Raum-Abtastsignale in dem dynamischen Sichtfeld mittels Fourier-Transformation in den zeitlichen Bereich transformiert werden, wobei die Daten zusätzlich in den Zeit-Frequenz-Bereich transformiert werden,
- die von den unterabgetasteten Signalen im k-Raum abgeleiteten erfassten Daten im Zeit-Frequenz-Bereich auf der Basis der räumlichen Empfindlichkeitsprofile der Anordnung von Empfangsantennen entfaltet werden, während ausgehend von Signalen im k-Raum-Bereich, die mit der Region der langsamen Veränderung in Beziehung stehen, transformierte Daten auf Null gestellt werden, und
- die resultierenden Daten in dem Zeit-Frequenz-Bereich mittels Fourier-Transformation in den Zeitbereich transformiert werden.

2. Magnetresonanz-Bildgebungsverfahren nach Anspruch 1, wobei der Reduzierungsfaktor eine ganze oder nicht ganze Zahl größer als 1 ist.

3. Magnetresonanz-Bildgebungsverfahren nach Anspruch 1 oder 2, wobei die Transformation vom k-Raum zum Zeit-Frequenz-Bereich eine Fourier-Transformation ist.

4. Magnetresonanz-Bildgebungsverfahren nach Anspruch 1 oder 2, wobei die Transformation vom k-Raum zum Zeit-Frequenz-Bereich mittels einer vorgegebenen Gruppe digitaler Filter durchgeführt wird.

5. Magnetresonanz-Bildgebungsgerät zum Erlangen eines dynamischen Bildes anhand einer Vielzahl von Signalen, das Folgendes umfasst:
- Mittel zum Anlegen eines stationären Magnetfelds und temporärer magnetischer Gradientenfelder,
- eine Anordnung aus mehreren Empfängerantennen zum Erfassen einer Vielzahl von Magnetresonanzsignalen auf unterabgetastete Weise, wobei die Magnetresonanzsignale auf der Basis der temporären Gradientenfelder räumlich codiert sind, **dadurch gekennzeichnet, dass** es weiterhin Folgendes umfasst:
- Mittel zum Segmentieren des abzubildenden Objekts in eine Region langsamer Veränderung unterhalb eines vorgegebenen Schwellenwertes und eine Region schneller Veränderung oberhalb des genannten Schwellenwertes, wobei die Region ein dynamisches Sichtfeld definiert, das in Bezug auf das Gesamtsichtfeld des abzubildenden Objekts eingeschränkt ist,
- Mittel zum Abtasten von Signalen in dem Gesamtsichtfeld im k-Raum mit einem Reduzierungsfaktor, der von der Anzahl der Erfassungs-Empfangsantennen und der Segmentierung des Sichtfeldes abhängt,
- Mittel zum Transformieren der k-Raum-Abtastsignale in dem dynamischen Sichtfeld mittels Fourier-Transformation in den zeitlichen Bereich, wobei die Daten zusätzlich in den Zeit-Frequenz-Bereich transformiert werden,
- Mittel zum Entfalten der von den unterabgetasteten Signalen im k-Raum abgeleiteten erfassten Daten im Zeit-Frequenz-Bereich auf der Basis der räumlichen Empfindlichkeitsprofile der Anordnung von Empfangsantennen, während ausgehend von Signalen im k-Raum-Bereich, die mit der Region der langsamen Veränderung in Beziehung stehen, transformierte Daten auf Null gestellt werden, und
- Mittel, um die resultierenden Daten in dem Zeit-Frequenz-Bereich mittels Fourier-Transformation in den Zeitbereich zu transformieren.

6. Auf einem von Computern nutzbarem Medium gespeichertes Computerprogrammprodukt zum Erstellen eines Bildes mittels eines Magnetresonanzverfahrens, mit einem computerlesbaren Programmmittel, das den Computer veranlasst, die Ausführung folgender Schritte zu steuern:
- Anlegen eines stationären Magnetfelds und temporärer magnetischer Gradientenfelder,
- Erfassen einer Vielzahl von Magnetresonanzsignalen auf unterabgetastete Weise mit Hilfe einer Anordnung aus mehreren Empfängerantennen, wobei die Magnetresonanzsignale auf der Basis der temporären Gradientenfelder räumlich codiert sind, **dadurch gekennzeichnet, dass** es weiterhin die folgenden Schritte umfasst:
- Segmentieren des abzubildenden Objekts in eine Region langsamer Veränderung unterhalb eines vorgegebenen Schwellenwertes und eine Region schneller Veränderung oberhalb des genannten Schwellenwertes, wobei die Region ein dynamisches Sichtfeld definiert, das in Bezug auf das Gesamtsichtfeld des abzubildenden Objekts eingeschränkt ist,
- Abtasten von Signalen in dem Gesamtsichtfeld im k-Raum mit einem Reduzierungsfaktor, der von der Anzahl der Erfassungs-Empfangsantennen und der Segmentierung des Sichtfeldes abhängt,
- Transformieren der k-Raum-Abtastsignale in dem dynamischen Sichtfeld mittels Fourier-Transformation in den zeitlichen Bereich, wobei die Daten zusätzlich in den Zeit-Frequenz-Bereich transformiert werden,
- Entfalten der von den unterabgetasteten Signalen im k-Raum abgeleiteten erfassten Daten im Zeit-Frequenz-Bereich auf der Basis der räumlichen Empfindlichkeitsprofile der Anordnung von Empfangsantennen, während ausgehend von Signalen im k-Raum-Bereich, die mit der Region der langsamen Veränderung in Beziehung stehen, transformierte Daten auf Null gestellt werden, und
- Transformieren der resultierenden Daten in dem Zeit-Frequenz-Bereich mittels Fourier-Transformation in den Zeitbereich.

## Revendications

1. Procédé d'imagerie par résonance magnétique pour former une image dynamique, dans lequel
- un champ magnétique stationnaire et des champs magnétiques provisoires de gradient sont appliqués,
- une pluralité de signaux de résonance magnétique est acquise d'une manière sous-échantillonnée au moyen d'un réseau d'antennes réceptrices multiples, les signaux de résonance magnétique étant codés de façon spatiale sur la base des champs provisoires de gradient, **caractérisé en ce que**
- l'objet à refléter est segmenté en une région de variation lente au-dessous d'un seuil prédéterminé et en une région de variation rapide au-dessus dudit seuil, laquelle région définit un champ de vision dynamique étant restreint en ce qui concerne le champ de vision global de l'objet à refléter,
- les signaux dans le champ de vision global sont échantillonnés dans l'espace k avec un facteur de réduction qui dépend du nombre d'acquisition d'antennes réceptrices et de la segmentation du champ de vision,
- les signaux d'échantillonnage de l'espace k dans le champ de vision dynamique sont transformés par transformée de Fourier en domaine temporel, lesquelles données sont transformées en plus en domaine temporel de fréquence,
- les données acquises dans le domaine temporel de fréquence qui sont dérivées des signaux sous-échantillonnés dans l'espace k sont révélées sur la base des profils spatiaux de sensibilité du réseau d'antennes réceptrices tandis que les données qui sont transformées à partir des signaux du domaine de l'espace k étant connexe à la région de variation lente sont réglées à zéro, et
- les données ainsi obtenues dans le domaine temporel de fréquence sont transformées par transformée de Fourier en domaine temporel.

2. Procédé d'imagerie par résonance magnétique selon la revendication 1, dans lequel le facteur de réduction est un nombre entier ou un nombre non-entier qui est supérieur à 1.

3. Procédé d'imagerie par résonance magnétique selon la revendication 1 ou 2, dans lequel la transformation à partir de l'espace k en domaine temporel de fréquence est une transformée de Fourier.

4. Procédé d'imagerie par résonance magnétique selon la revendication 1 ou 2, dans lequel la transformation à partir de l'espace k en domaine temporel de fréquence est accomplie par un ensemble prédéterminé de filtres numériques.

5. Appareil d'imagerie par résonance magnétique pour obtenir une image dynamique à partir d'une pluralité de signaux comprenant
- des moyens pour appliquer un champ magnétique stationnaire et des champs magnétiques provisoires de gradient,
- un réseau d'antennes réceptrices multiples pour acquérir d'une manière sous-échantillonnée une pluralité de signaux de résonance magnétique, les signaux de résonance magnétique étant codés de façon spatiale sur la base des champs provisoires de gradient, **caractérisé en ce qu'**il comprend encore:
- des moyens pour segmenter l'objet à refléter en une région de variation lente au-dessous d'un seuil prédéterminé et en une région de variation rapide au-dessus dudit seuil, laquelle région définit un champ de vision dynamique étant restreint en ce qui concerne le champ de vision global de l'objet à refléter,
- des moyens pour échantillonner des signaux dans le champ de vision global dans l'espace k avec un facteur de réduction qui dépend du nombre d'acquisition d'antennes réceptrices et de la segmentation du champ de vision,
- des moyens pour transformer les signaux d'échantillonnage de l'espace k dans le champ de vision dynamique par transformée de Fourier en domaine temporel, lesquelles données sont transformées en plus en domaine temporel de fréquence,
- des moyens pour révéler les données acquises dans le domaine temporel de fréquence qui sont dérivées des signaux sous-échantillonnés dans l'espace k sur la base des profils spatiaux de sensibilité du réseau d'antennes réceptrices tandis que les données qui sont transformées à partir des signaux du domaine de l'espace k étant connexe à la région de variation lente sont réglées à zéro, et
- des moyens pour transformer par transformée de Fourier les données ainsi obtenues dans le domaine temporel de fréquence en domaine temporel.

6. Produit de programme informatique qui est stocké sur un milieu exploitable par l'ordinateur pour former une image au moyen d'un procédé de résonance magnétique comprenant un programme lisible par l'ordinateur pour effectuer que l'ordinateur commande l'exécution de:
- l'application d'un champ magnétique stationnaire et de champs magnétiques provisoires de gradient,
- l'acquisition d'une manière sous-échantillonnée d'une pluralité de signaux de résonance magnétique au moyen d'un réseau d'antennes réceptrices multiples, les signaux de résonance magnétique étant codés de façon spatiale sur la base des champs provisoires de gradient, **caractérisé en ce qu'**il comprend encore:
- la segmentation de l'objet à refléter en une région de variation lente au-dessous d'un seuil prédéterminé et en une région de variation rapide au-dessus dudit seuil, laquelle région définit un champ de vision dynamique étant restreint en ce qui concerne le champ de vision global de l'objet à refléter,
- l'échantillonnage des signaux dans le champ de vision global dans l'espace k avec un facteur de réduction qui dépend du nombre d'acquisition d'antennes réceptrices et de la segmentation du champ de vision,
- la transformation des signaux d'échantillonnage de l'espace k dans le champ de vision dynamique par transformée de Fourier en domaine temporel, lesquelles données sont transformées en plus en domaine temporel de fréquence,
- la révélation des données acquises dans le domaine temporel de fréquence qui sont dérivées des signaux sous-échantillonnés dans l'espace k sur la base des profils spatiaux de sensibilité du réseau d'antennes réceptrices tandis que les données qui sont transformées à partir des signaux du domaine de l'espace k étant connexe à la région de variation lente sont réglées à zéro, et
- la transformation par transformée de Fourier les données ainsi obtenues dans le domaine temporel de fréquence en domaine temporel.
